(19) **Europäisches Patentamt / European Patent Office / Office européen des brevets**

(11) **EP 1 863 073 A1**

(12) **EUROPEAN PATENT APPLICATION**
published in accordance with Art. 158(3) EPC

(43) Date of publication:
**05.12.2007 Bulletin 2007/49**

(51) Int Cl.:
**H01L 21/304** (2006.01)    **B24B 37/00** (2006.01)

(21) Application number: **06715133.2**

(22) Date of filing: **03.03.2006**

(86) International application number:
**PCT/JP2006/304050**

(87) International publication number:
**WO 2006/095643 (14.09.2006 Gazette 2006/37)**

(84) Designated Contracting States:
**DE FR GB**

(30) Priority: **07.03.2005 JP 2005061735**

(71) Applicant: **Nihon Microcoating Co., Ltd.**
**Akishima-shi,**
**Tokyo 1960021 (JP)**

(72) Inventors:
- **KOBAYASHI, Toshihiro**
**-chome, Akishima-shi, Tokyo 1960021 (JP)**

- **IZUMI, Toshihiro**
**-chome, Akishima-shi, Tokyo 1960021 (JP)**
- **TAMURA, Jun**
**-chome, Akishima-shi, Tokyo 1960021 (JP)**
- **NAGAMINE, Takuya**
**-chome, Akishima-shi, Tokyo 1960021 (JP)**
- **ARAHATA, Takashi**
**-chome, Akishima-shi, Tokyo 1960021 (JP)**

(74) Representative: **Lerwill, John et al**
**A.A. Thornton & Co.**
**235 High Holborn**
**London, WC1V 7LE (GB)**

(54) **POLISHING PAD**

(57)    A polishing pad capable of polishing the surface of a wafer more flatly and more uniformly is provided. A polishing pad includes a main body 11 having a polishing surface and a backing 12 that is affixed to the back surface of the main body 11. The elasticity of the main body is within the range of 600psi-16000psi and preferably within the range of 1600psi-16000psi when a compressive pressure of 2psi-l6psi is applied, and the thickness of the main body is within the range of 0.5mm-3.0mm. The elasticity of the backing is lower than that of the main body and exceeds 300psi when a compressive pressure of 2psi-l6psi is applied.

[Fig. 1]

**Description**

**Technical Field**

This invention relates to a polishing pad for use in polishing target objects such as semiconductor wafers and magnetic hard disk substrates that require a surface with a high degree of flatness and in particular to such a polishing pad suited for use for the planarization of a wafer in the production process of semiconductor devices.

**Background of the Invention**

In the production process of semiconductor devices, metal wiring layers for mutually connecting elements such as transistors, capacitors and resistors are coming to be multi-layered and this is commonly done by the photo-lithography technology or the damascene method. By the photolithography technology, a wiring pattern is exposed to light and metal wires are stacked. By this method, however, step differences tend to be formed on the surface of the device when an insulating film between layers is deposited on a metal wiring layer and if the unevenness on the surface of the device due to such step differences becomes larger than the focusing depth of the light exposure, the accuracy in the width and shape of the pattern become adversely affected and the manufacturing throughput of the semiconductor devices becomes lower. In other words, if the unevenness on the device surfaces due to such step differences is made smaller, the manufacturing throughput of semiconductor devices can be improved because the exposure margin in optical lithography can be secured and very fine patterning and etching on the wiring layers can be accurately and easily carried out. By the damascene method, on the other hand, a multi-layered wiring is formed by depositing a wiring metal (Cu) after wiring grooves are formed on the insulating film and leaving the wiring metal only inside the grooves by a polishing process but there is a problem of so-called dishing in that the center part of the metal wiring may become thin due to the polishing. For this reason, planarization of the device surface is an important step of the production process.

Planarization is being carried out by using the so-called chemical mechanical polishing (CMP) technology. The CMP technology is a polishing technology with both a chemical dissolving operation by a liquid chemical and a mechanical removal operation, dissolving the device surface chemically by using a liquid chemical and polishing it mechanically with abrading particles. It is a widely used polishing technology because no altered layer (surface portion different from the interior, generated by the fabrication process) is generated.

Planarization by CMP is generally carried out by rotating a lapping plate or a platen on which a polishing pad is attached, supplying the surface of the polishing pad with slurry causing small abrading particles selected from particles of silica, alumina, ceria, zirconia, etc. to be dispersed within an alkaline or acidic fabrication liquid and pressing thereonto the surface of the wafer (or the device surface) attached to a polishing head or a carrier.

In the technical field of production of semiconductors, on the other hand, it is being required to develop a new technology for polishing the surface of a wafer flatly and evenly such that finer multi-layered wiring patterns can be formed with a high level of accuracy.

During a polishing process, the polishing pad undergoes an elastic deformation, since it is attached to the surface of a rotating lapping plate and a wafer is pressed to it, as described above. Thus, if the elasticity of the polishing pad is too great, the part of the insulating layer between the wiring lines and the phenomenon of dishing may take place such that step differences (or so-called residual step differences) come to be formed on the surface of the wafer.

In view of the above, it is being investigated to harden the polishing pad so as to reduce its elastic deformation during the polishing operation Patent Document 1, for example, discloses a polishing pad having a relatively hard pad main body with elasticity on the order of 400psi and a backing with a smaller elasticity (bulk modulus) than that of the main body of 250psi or less attached to the back surface of the main body. As an example, pads with main body of foamed polyurethane with elasticity 400psi (product name IC1000 produced by Rodel Nitta Co.) and a backing with elasticity 250psi (product name SUBA400 produced by Rodel Nitta Co.) attached to the back surface of the main body are commercially available.

[Patent Document 1] Japanese Patent Publication Tokkai 6-21028,

**Disclosure of the Invention**

**Problems to be solved by the Invention**

In the field of semiconductor production, as described above, it is coming to be required to develop a new technology for polishing the surface of a wafer more flatly and uniformly. In recent years, in particular, it is coming to be required to develop a technology for accomplishing a step difference relaxation of about 95% or more and so-called "within wafer non-uniformity" (or "wiwnu") of about 7% or less, independently of the density of the wiring. In the above, the step difference relaxation is a value (in the unit of %) obtained by dividing the difference between the initial step difference and the residual step difference by the initial step difference and then multiplying by 100.

The closer does this value approach 100, the smaller is the residual step difference and the flatter is the surface shown to have been made. The within wafer non-uniformity is for showing the polishing rate at each point on the surface as the standard deviation $\sigma$ (in the unit of %). The smaller is this value, the smaller is the fluctuation in the polishing rate among the points in the surface and the more uniform is the surface shown to have been polished.

With a prior art polishing pad described above, although a step difference relaxation of 97.8% has been accomplished with a pattern formed on a wafer having straight-line protrusions of widths $20\mu$m and straight-line indentations with widths $80\mu$m and depths $80\mu$m alternately formed, a step difference relaxation of only 78.7% can be accomplished in the case of a pattern on a wafer having straight-line protrusions of widths $80\mu$m and straight-line indentations with widths $20\mu$m and depths $80\mu$m alternately formed. The differences in the residual step differences due to the difference in the density of the wafer surface pattern are too large, and the outer peripheral portions of the wafer are polished excessively such that a within wafer non-uniformity of only 7.2% can be accomplished. In other words, currently available prior art polishing pads cannot accomplish the flatness and uniformity required in the field of semiconductor production.

It is therefore an object of this invention to provide a polishing pad capable of polishing the surface of a wafer (that is, the surface of a device) more flatly and more uniformly.

**Means for solving the problems**

A polishing pad according to this invention may be characterized as comprising a main body having a polishing surface and a backing that is affixed to the back surface of the main body.

The elasticity of the main body is within the range of 600psi-16000psi and preferably within the range of 1600psi-16000psi when a compressive pressure of 2psi-16psi is applied.

The thickness of the main body is within the range of 0.5mm-3.0mm.

A pad made of a foamed material using a synthetic resin as its material, a pad of a non-foamed material using a synthetic resin as its material, a pad made of a non-woven cloth comprising synthetic fibers, a pad comprising a synthetic resin having microcapsules mixed thereinto and a pad comprising a synthetic resin having particles mixed thereinto may be used as the main body.

The elasticity of the backing is lower than that of the main body and exceeds 300psi when a compressive pressure of 2psi-16psi is applied.

A pad made of a foamed material using a synthetic resin as its material, a pad of a non-foamed material using a synthetic resin as its material, a pad made of a non-woven cloth comprising synthetic fibers, a pad comprising a synthetic resin having microcapsules mixed thereinto and a pad comprising a synthetic resin having particles mixed thereinto may be used as the backing.

**Effect of the Invention**

With a polishing pad comprised as above, a step difference relaxation of about 95% or above and a within wafer non-uniformity of about 7% or less can be accomplished and the surface of a wafer can be polished more smoothly and uniformly.

**Mode for carrying out the Invention**

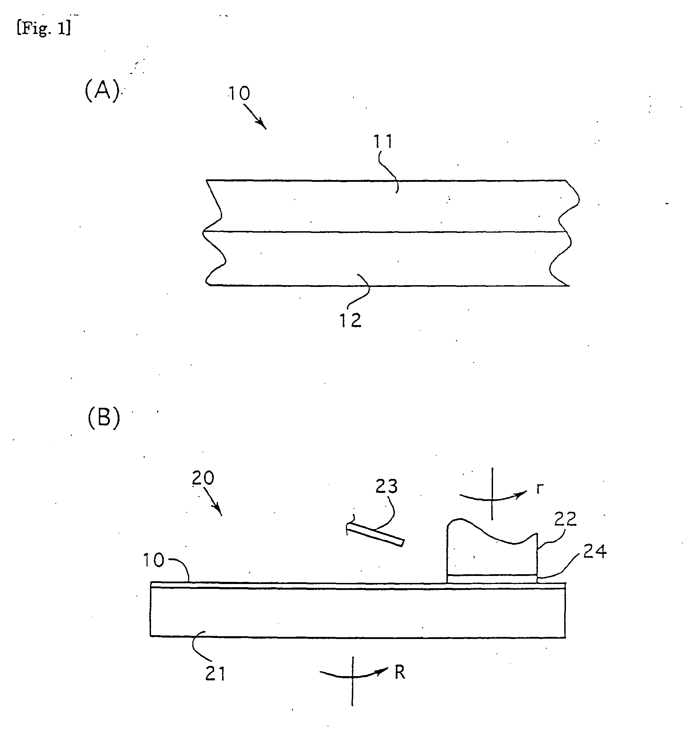

Fig. 1A shows a polishing pad 10 according to this invention, comprising a main body 11 with a polishing surface and a backing 12 affixed to the back surface of this main body 11.

<Main Body of Pad> The elasticity of the main body 11 is within the range of 600psi-16000psi and preferably 1600psi-16000psi under a compressive pressure of 2psi-16psi. If it is less than 600psi, its elastic deformation becomes too large during the polishing such that the interior of the indentations of the wafer surface (or the device surface) is polished excessively and residual step differences are generated. If the elasticity of the main body 11 exceeds 16000psi, the main body 11 is hardly compressed and since it ceases to be deformed under pressure, unwanted scratches may be formed on the wafer surface.

In what follows, elasticity is defined such that an initial compressive pressure is assumed to be 2psi and the thickness under this initial compressive pressure is defined to be zero. The maximum compressive pressure is taken as 16psi, and the elasticity is obtained from the thickness under this maximum compressive pressure or the amount of compression as the compressive pressure is increased from the initial compressive pressure to the maximum compressive pressure. From the practical point of view, the polishing pressure (that is, the pressure with which the wafer surface is pressed against the surface of the polishing pad or the surface of its main body) is between the initial and maximum pressures, or within the range of 2psi-16psi.

Since the elasticity and the compressibility are related as shown by Formula (1) given below:

$$\text{(Elasticity)} = \text{(Compressive pressure)}/\text{(Compressibility)}, \qquad \text{Formula (1)}$$

the main body 11 has compressibility within the range of 0.1%-about 2.7% (or elasticity = 600psi-16000psi), or preferably 0.1%-1.0% (or elasticity = 1600psi-16000psi).

As the main body 11 of the pad 10, non-foamed members of a synthetic resin material selected from the group of known thermoplastic or thermosetting resins consisting of polyester, polyurethane, polypropylene, nylon, acryl and epoxy resins may be used. Such main bodies may be produced by placing inside a mold a resin solution prepared by adding a hardener to a synthetic resin, hardening it inside the mold, forming a block of a non-foamed material and slicing it to a specified thickness. They may be produced also by a known sheet molding method such as the protrusion and injection molding methods.

The compression recovery ratio of this main body made of a non-foamed material is within the range of 50% or greater, or preferably 70% or greater. If the compression recovery ratio is less than 50%, it is difficult to follow the unevenness on the device surface such that fluctuations are likely to result on the elastic recovery force of the pad at various points on the wafer surface. As a result, the pad surface cannot act uniformly over the wafer surface, resulting in a fluctuation in the stock removal at various points on the wafer surface and the wafer surface cannot be uniformly polished. The compression recovery ratio is a number representing the quantity of displacement recovered within a certain time period after the main body is deformed with a specified compressive force, indicating the ratio (in %) of the recovered displacement with respect to the compressive displacement.

A foamed pad made of a foamed material obtained from a synthetic resin material such as polyurethane (such as disclosed in Japanese Patent Publication Tokkai 2000-269170), a pad of a non-woven cloth comprising synthetic fibers (such as disclosed in Japanese Patent Publication Tokkai 2000-239651), or a pad comprising a synthetic resin with micro-capsules mixed in (such as disclosed in Japanese Patent Publication Tokkai 11-285961) may be used as the main body 11. In order to improve the polishing rate, pads comprising a synthetic resin with particles of ceria, alumina or diamond mixed in as abrading particles and pads comprising a synthetic resin mixed with synthetic resin particles (beads) serving as a filler for adjusting the hardness of the pad may be used. Any such pads in a planar shape having the elasticity within the range described above may be used as the main body 11.

Although not illustrated in the figures, the main body 11 may have grooves formed on its surface (or its polishing surface) in order to prevent the adsorption of the wafer and to reduce the so-called hydroplane phenomenon. The area of the grooved portions formed on the surface of the main body 11 (or the area of the grooves as the surface of the main body is considered to be flat) is within the range of 10%-50% of the total surface area (considered to be 100%) of the main body 11. The grooves may be formed in any geometrical pattern with straight and/or curved lines and their combinations such as a concentric circular pattern and a lattice pattern.

The thickness of the main body 11 is within the range of 0.5mm-3.0mm. If it is less than 0.5mm, elasticity of the polishing pad 10 as a whole comes to depend on the backing 12 with elasticity lower than that of the main body 11 such that the elastic recovery force becomes low and that step differences come to be formed easily on the wafer surface. If the thickness of the main body 11 exceeds 3.0mm, on the other hand, elasticity of the polishing pad 10 as a whole comes to depend on the main body 11 such that the ability to follow the wafer surface becomes adversely affected and that it becomes difficult to uniformly polish the wafer surface.

<Backing> The elasticity of the backing 12 is within a range lower than that of the main body 11 and in excess of 300psi under a compressive pressure of 2psi-16psi.

This is because the ability of the main body 11 to follow the wafer surface improves during the polishing if a member with the elasticity lower than that of the main body 11 is used as the backing 12.

It is also because the step difference relaxation comes to depend too heavily on the density of the pattern on the wafer surface if the elasticity of the backing 12 is below 300psi such that the flatness of the wafer (about 95% or over in step difference relaxation) and its within wafer non-uniformity (about 7% or less over the surface) required in the field of semiconductor production cannot be obtained.

As the backing 12, as explained above for the main body 11, non-foamed members of a synthetic resin material selected from the group of known thermoplastic or thermosetting resins consisting of polyester, polyurethane, polypropylene, nylon, acryl and epoxy resins may be used. Such backing sheets may be produced, like the main body 11 described above, by placing inside a mold a resin solution prepared by adding a hardener to a synthetic resin, hardening it inside the mold, forming a block of a non-foamed material and slicing it to a specified thickness. They may be produced also by a known sheet molding method such as the protrusion and injection molding methods.

A foamed pad made of a foamed material obtained from a synthetic resin material such as polyurethane, a pad of a non-woven cloth comprising synthetic fibers, a pad comprising a synthetic resin with micro-capsules mixed in, or a pad of a synthetic resin having particles mixed in may be used as the backing 12 having the elasticity within the range described above.

Between the elasticity of the main body 11 and that of the backing 12 used for the polishing pad 10 of the present invention, there is a relationship as shown by Formula (2) shown below:

$$(Y>X) \cap (16000 \geq Y \geq 600) \cap (X>300) \qquad \text{Formula (2)}$$

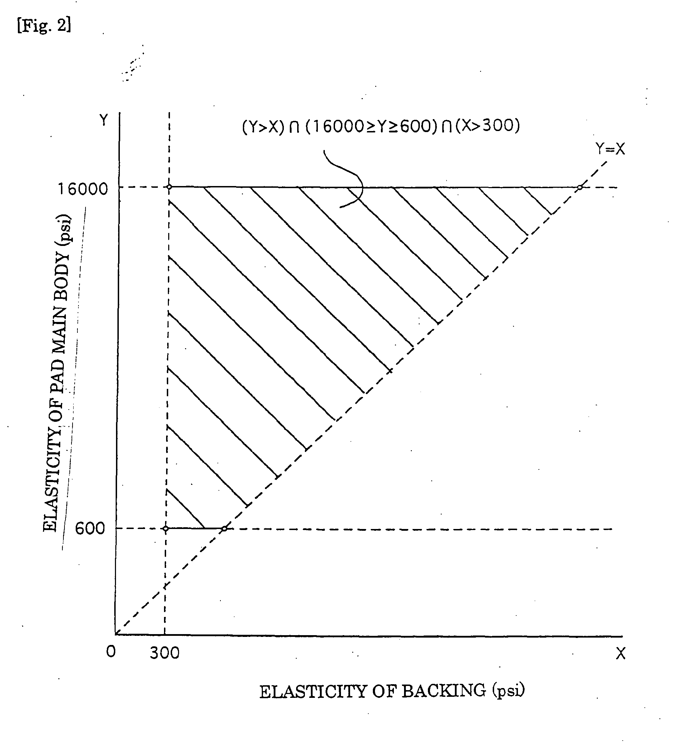

where Y (in units of psi) is the elasticity of the main body 11 and X (in units of psi) is that of the backing 12. Fig. 2 is a graph that shows Formula (2). Elasticity of the main body 11 and that of the backing 12 to be used for the polishing pad 10 of this invention are inside the shaded area shown in Fig. 2.

The invention is described next by way of embodiments. If an inter-layer insulating film is stacked on a metal wiring formed on a wafer when a semiconductor device is produced, step differences are formed on the surface of this wafer.

Such step differences are removed according to this invention in order to planarize the wafer surface (or the device surface) by using a CMP device 20 shown in Fig. 1B to polish the surface of the wafer 24.

With reference to Fig. 1B, the surface of the wafer 24 is polished first by attaching the polishing pad 10 of this invention to the surface of a lapping plate (or a platen) 21 by means of an adhesive tape and rotating the lapping plate 21 in the direction of arrow R. Slurry is supplied to the surface of the polishing pad 10 through a nozzle 23, the surface of the wafer 24 attached to a polishing head (or a carrier) 22 is pressed against the surface of the polishing pad 10, and it is rotated in the direction of arrow r.

Abrading particles are dispersed in water or a water-based aqueous solution and a reaction liquid that reacts chemically with the surface material of the wafer (such as sodium hydroxide and ammonia) is added to it to obtain slurry to be used.

The pressure with which the wafer 24 is pressed against the surface of the polishing pad 10 (or the polishing surface of its main body 11) is selected from the range of 2psi-10psi.

<Test Example 1> A resin solution was prepared by adding 29 parts of 3,3'-dichlor-4,4'-diamino-diphenyl methane as hardener to 100 parts of TDI (trilene diisocyanate) type urethane prepolymer of average molecular weight about 900. This resin solution was placed inside a mold to cause it to harden inside the mold to form a non-foamed block. It was sliced to the thickness of 1.5mm and a lathe was used to form spiral grooves (with land width=0.6mm, groove width=0.3mm, groove occupancy ratio=33.3%) on the surface of these slices to obtain pad main bodies with elasticity 1600psi (and compressibility 1.0%).

Polymer polyol, 3 functional polyol, polyisocyanate amine bridging agent and tertiary amine catalyst were adjusted at ratios such that the Shore hardness under the non-foamed condition would be 75 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become $0.66 \text{g/cm}^3$ in density, foamed and dried such that foamed sheets with thickness 1.3mm and elasticity 750psi were obtained. These foamed sheets were pasted as backings on the back surfaces of the main bodies as described above to obtain polishing pads of Test Example 1.

< Test Example 2> Polymer polyol, 3 functional polyol, polyisocyanate amine bridging agent and tertiary amine catalyst were adjusted at ratios such that the Shore hardness under the non-foamed condition would be 85 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become $0.66 \text{g/cm}^3$ in density, foamed and dried such that foamed sheets with thickness 1.3mm and elasticity 500psi were obtained. These foamed sheets were pasted as backings on the back surfaces of the main bodies produced as described above in Test Example 1 to obtain polishing pads of Test Example 2.

< Test Example 3> Polymer polyol, 3 functional polyol, polyisocyanate amine bridging agent and tertiary amine catalyst were adjusted at ratios such that the Shore hardness under the non-foamed condition would be 70 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become $0.48 \text{g/cm}^3$ in density, foamed and dried such that foamed sheets with thickness 1.3mm and elasticity 400psi were obtained. These foamed sheets were pasted as backings on the back surfaces of the main bodies produced as described above in Test Example 1 to obtain polishing pads of Test Example 3.

< Test Example 4> Polymer polyol, 3 functional polyol, polyisocyanate amine bridging agent and tertiary amine catalyst were adjusted at ratios such that the Shore hardness under the non-foamed condition would be 65 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become 0.55g/cm$^3$ in density, foamed and dried such that foamed sheets with thickness 1.3mm and elasticity 300psi were obtained. These foamed sheets were pasted as backings on the back surfaces of the main bodies produced as described above in Test Example 1 to obtain polishing pads of Test Example 4.

< Test Example 5> A resin solution was prepared by adding 30 parts of polyol as hardener to 100 parts of HDI (hexamethylene diisocyanate) type urethane prepolymer of average molecular weight about 500. This resin solution was placed inside a mold to cause it to harden inside the mold to form a non-foamed block. It was sliced to the thickness of 1.5mm and a lathe was used to form spiral grooves (with land width=0.6mm, groove width=0.3mm, groove occupancy ratio=33.3%) on the surface of these slices to obtain pad main bodies with elasticity 4800psi (and compressibility 0.5%).

Polymer polyol, 3 functional polyol, polyisocyanate amine bridging agent and tertiary amine catalyst were adjusted at ratios such that the Shore hardness under the non-foamed condition would be 65 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become 0.66g/cm$^3$ in density, foamed and dried such that foamed sheets with thickness 1.3mm and elasticity 500psi were obtained. These foamed sheets were pasted as backings on the back surfaces of the main bodies as described above to obtain polishing pads of Test Example 5.

< Comparison Example 1> Polymer polyol, 3 functional polyol, polyisocyanate amine bridging agent and tertiary amine catalyst were adjusted at ratios such that the Shore hardness under the non-foamed condition would be 80 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become 0.32g/cm$^3$ in density, foamed and dried such that foamed sheets with thickness 1.3mm and elasticity 200psi were obtained. These foamed sheets were pasted as backings on the back surfaces of the main bodies produced as described above in Test Example 1 to obtain polishing pads of Comparison Example 1.

< Comparison Example 2> Polymer polyol, 3 functional polyol, polyisocyanate amine bridging agent and tertiary amine catalyst were adjusted at ratios such that the Shore hardness under the non-foamed condition would be 70 degrees. These materials were mixed at such ratios, and a appropriate amounts of foaming agent and adjuster of bubble size and shape were added to prepare a resin mixture. Next, this resin mixture was applied on the surface of a base material in the shape of a sheet comprising polyethylene terephthalate. It was heated inside an oven at 100°C such that this resin mixture would become 0.32g/cm$^3$ in density, foamed and dried such that foamed sheets with thickness 1.3mm and elasticity 60.0psi were obtained. These foamed sheets were pasted as backings on the back surfaces of the main bodies produced as described above in Test Example 1 to obtain polishing pads of Comparison Example 2.

< Comparison Example 3> Commercially available foamed pads (product name: IC1000/S400 produced by Rohm and Haas Electronic Materials CMP Holdings, Inc.) were used as polishing pads of Comparison Example 3. The elasticity of the main bodies of these polishing pads was 400psi and that of their backings was 200psi.

The elasticity of the main body and backing of each of the polishing pads of Test Examples 1-5 and Comparison Examples 1-3 is shown in Table 1.

Table 1

| | Elasticity (psi) | |
|---|---|---|
| | Main body | Backing |
| Test Example 1 | 1600 | 750 |
| Test Example 2 | 1600 | 500 |
| Test Example 3 | 1600 | 400 |
| Test Example 4 | 1600 | 300 |
| Test Example 5 | 4800 | 500 |
| Comparison Example 1 | 1600 | 200 |
| Comparison Example 2 | 1600 | 60 |
| Comparison Example 3 | 400 | 200 |

< Polishing Test 1> Each of the polishing pads of Test Examples 1-5 and Comparison Examples 1-3 was used to polish the surface of a wafer and the step difference relaxation was examined.

Test wafers of a know kind (SKW7-2) widely used for evaluation tests for flatness were used for the testing. These wafers are produced by using a specified mask pattern to etch the surface of a silicon substrate and forming a silicon oxide film on it by a CVD method. In a comparison test, step differences on patterns D20 and D80 were compared corresponding to the stock removal of pattern D100 of a test wafer after being polished with each of the polishing pads. In the above, pattern D100 means the part on a test wafer having no unevenness, pattern D20 is a part on a test wafer where straight-line protrusions with width 20μm and straight-line indentations with widths 80μm and depths 80μm are alternately formed and pattern D80 is a part on a test wafer where straight-line protrusions with widths 80μm and straight-line indentations with width 20μm and depths 80μm are alternately formed.

A commercially available CMP device (product number MAT-ARW681 S produced by MTT, Inc) as shown in Fig. 1B was used as the polishing device. The conditions for the polishing were as shown in Table 2 below. Slurry obtained by diluting commercially available mother liquid (product name: Semi Sperse25, produced by Cabot Microelectronics Japan Corporation) with pure water to two times (or ratio of mother liquid: water = 1:1).

Table 2

| Rotary speed of lapping plate | 60rpm |
| Rotary speed of polishing head | 63rpm |
| Load on polishing head (polishing pressure) | 3psi |
| Load on retainer ring | 5psi |
| Speed of oscillating motion | 1mm/minute |
| Distance of oscillating motion | 10mm |
| Slurry flow rate | 200cc/minute |

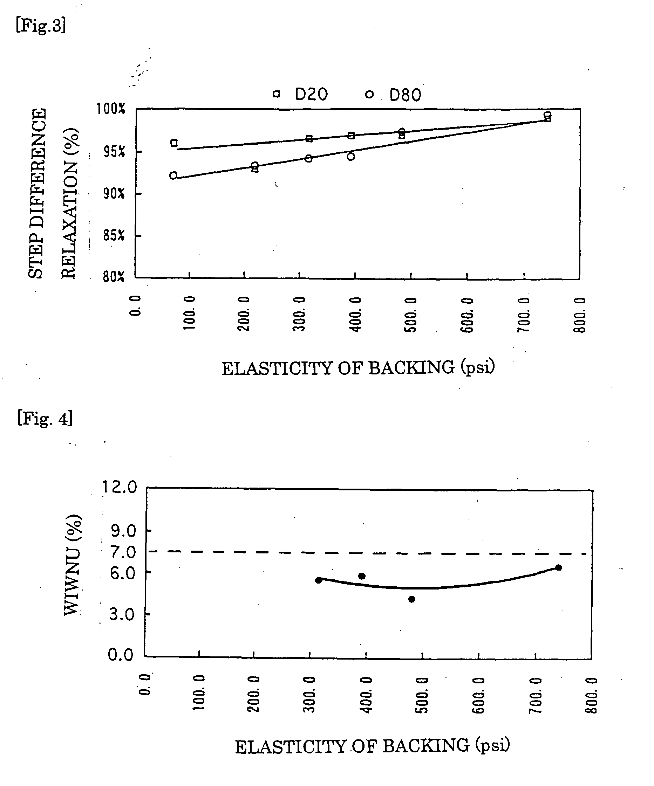

< Test Results 1> The results of Polishing Test 1 are shown in Table 3 below and Fig. 3.

Table 3

|  | Step difference relaxation (%) | |
| --- | --- | --- |
|  | D80 | D20 |
| Test Example 1 | 99 | 99 |
| Test Example 2 | 97 | 97 |
| Test Example 3 | 94 | 97 |
| Test Example 4 | 94 | 96 |
| Test Example 5 | 98 | 98 |
| Comparison Example 1 | 93 | 93 |
| Comparison Example 2 | 92 | 96 |
| Comparison Example 3 | 79 | 98 |

According to this invention, wafers can be polished more smoothly than if polishing pads of Comparison Examples 1 and 2 are used and step difference relaxation of better than 95% can be accomplished.

Table 3 and Fig. 3 show that the step difference relaxation approaches 100% if the elasticity of the backing is increased independently of the density of the pattern on the wafer surface. The results of Polishing Test 1 point oppositely to the showing in aforementioned Japanese Patent Publication Tokkai 6-21028 that the elasticity of the backing for prior art polishing pads be in a range of 250psi or less.

< Polishing Test 2> Each of polishing pads of Test Examples 1-4 was used to polish the surface of wafer with a PTEOS film and without any pattern on the surface and the within wafer non-uniformity was examined.

A polishing device identical to the one used in Polishing Test 1 was used and the polishing was carried out under the same conditions as shown in Table 2. Slurry identical to that used in Polishing Test 1 was used.

< Test Results 2> The results of Polishing Test 2 are shown in Table 4 below and Fig. 4.

Table 4

| | Within wafer non-uniformity (%) |
|---|---|
| Test Example 1 | 6.5 |
| Test Example 2 | 4.2 |
| Test Example 3 | 5.9 |
| Test Example 4 | 5.6 |
| Test Example 5 | 4.8 |

As explained above, the within wafer non-uniformity is a parameter which represents the fabrication-uniformity within the wafer surface, indicated by the standard variation (σ) (%) of the stock removal at each point within the surface. The smaller this value, the smaller is the fluctuation in the stock removal.

Table 4 and Fig. 4 show that within wafer non-uniformity values of about 7% and less can be accomplished and that the wafer surface can be polished uniformly according to this invention.

**Brief Description of the Drawings**

[Fig. 1]    Fig. 1A is a sectional view of a polishing pad according to this invention, and Fig. 1B shows an example of CMP device for carrying out the present invention.

[Fig. 2]    Fig. 2 is a graph that shows the relationship between the elasticity of the main body and that of the backing of a polishing pad of this invention.

[Fig. 3]    Fig. 3 shows the results of Polishing Test 1.

[Fig. 4]    Fig. 4 shows the results of Polishing Test 2.

Numerals

10    polishing pad
11    main body of pad
12    backing
20    CMP device
21    lapping plate
22    polishing head
23    nozzle
24    wafer

**Claims**

1.  A polishing pad comprising:

    a main body having a polishing surface; and
    a backing affixed to the back surface of said main body;

    wherein said main body has elasticity within the range of 600psi-16000psi when a compressive pressure of 2psi-16psi is applied; and
    wherein said backing, when a compressive pressure of 2psi-16psi is applied, has elasticity lower than the elasticity of said main body and exceeds 300psi.

2.  The polishing pad of claim 1 wherein said main body has elasticity within the range of 1600psi-16000psi when a compressive pressure of 2psi-16psi is applied

3. The polishing pad of claim 2 wherein said main body has a thickness of 0.5mm-3.0mm.

4. The polishing pad of claim 1 wherein said main body comprises one selected from the group consisting of pads made of a foamed material having a synthetic resin as material thereof; pads made of a non-woven cloth comprising synthetic fibers; pads made of a synthetic resin having microcapsules mixed thereinto.

5. The polishing pad of claim 1 wherein said backing comprises one selected from the group consisting of pads made of a foamed material having a synthetic resin as material thereof; pads made of a non-woven cloth comprising synthetic fibers; pads made of a synthetic resin having microcapsules mixed thereinto.

[Fig. 1]

(A)

(B)

[Fig. 2]

$(Y>X) \cap (16000 \geq Y \geq 600) \cap (X>300)$

Y = X

ELASTICITY OF PAD MAIN BODY (psi)

16000

600

ELASTICITY OF BACKING (psi)

0    300    X

[Fig.3]

[Fig. 4]

## INTERNATIONAL SEARCH REPORT

| International application No. |
| --- |
| PCT/JP2006/304050 |

A.   CLASSIFICATION OF SUBJECT MATTER
*H01L21/304*(2006.01), *B24B37/00*(2006.01)

According to International Patent Classification (IPC) or to both national classification and IPC

B.   FIELDS SEARCHED

Minimum documentation searched (classification system followed by classification symbols)
*H01L21/304*(2006.01), *B24B37/00*(2006.01)

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| A | WO 91/14538 A1  (WESTECH SYSTEMS INC.), 03 October, 1991 (03.10.91), Full text & JP 5-505769 A          & JP 6-21028 A | 1-5 |
| A | JP 8-132342 A  (Hitachi, Ltd.), 28 May, 1996 (28.05.96), Full text (Family: none) | 1-5 |
| A | JP 2000-202763 A  (Toray Industries, Inc.), 25 July, 2000 (25.07.00) Full text & EP 1138438 A1 | 1-5 |

☐   Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 24 May, 2006 (24.05.06) | Date of mailing of the international search report 06 June, 2006 (06.06.06) |
| --- | --- |
| Name and mailing address of the ISA/ Japanese Patent Office | Authorized officer |
| Facsimile No. | Telephone No. |

Form PCT/ISA/210 (second sheet) (April 2005)

**EP 1 863 073 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6021028 A
- JP 2000269170 A
- JP 2000239651 A
- JP 11285961 A